# FASCICULE DE BREVET EUROPEEN

(11) **EP 1 303 042 B1**
(45) Date de publication et mention de la délivrance du brevet: **05.12.2018**
(21) Numéro de dépôt: 01203808.9
(22) Date de dépôt: 09.10.2001
(51) Int. Cl.: H03H 9/215, H03H 9/05

(54) **Résonateur piézoélectrique et ensemble comprenant un tel résonateur enfermé dans un boîtier**
Piezolelektrischer Resonator und Einheit, die einen solchen Resonator eingeschlossen in einem Gehäuse enthält
Piezoelectrical resonator and unit comprising such a resonator enclosed in a case

(43) Date de publication de la demande: 16.04.2003
(73) Titulaire: Eta SA Fabriques d'Ebauches, 2540 Grenchen (CH)
(72) Inventeur: Dalla Piazza, Silvio, 2610 St-Imier (CH); Lüthi, Thomas, 2540 Grenchen (CH); Studer, Bruno, 4533 Riedholz (CH)
(74) Mandataire: Ravenel, Thierry Gérard Louis

(56) Documents cités:
- DE-A- 19 902 339
- GB-A- 1 425 435
- GB-A- 1 465 863
- JP-A- 54 003 487
- JP-U- 50 085 170
- PATENT ABSTRACTS OF JAPAN vol. 015, no. 024 (P-1156), 21 janvier 1991 (1991-01-21) & JP 02 268220 A (TOKYO KEIKI CO LTD), 1 novembre 1990 (1990-11-01)
- PATENT ABSTRACTS OF JAPAN vol. 007, no. 267 (E-213), 29 novembre 1983 (1983-11-29) & JP 58 150317 A (CITIZEN TOKEI KK), 7 septembre 1983 (1983-09-07)

## Description

La présente invention concerne les résonateurs piézoélectriques et plus particulièrement les résonateurs de petites dimensions qui sont utilisés le plus souvent pour la réalisation de générateurs de fréquences notamment pour des équipements électroniques portables, dans de nombreux domaines comme l'horlogerie, l'informatique, les télécommunications et la médecine.

La plupart des résonateurs à quartz de petites dimensions qui sont utilisés actuellement en horlogerie et en particulier dans les montres électroniques ou électromécaniques sont des résonateurs à diapason en quartz qui sont enfermés sous vide ou sous atmosphère de gaz inerte dans des boîtiers dits « métalliques ».

Ces boîtiers métalliques sont des boîtiers de forme allongée qui comprennent une embase de contour essentiellement cylindrique sur laquelle est chassé un capot métallique également cylindrique qui peut être fabriqué avantageusement par emboutissage. Dans ce cas, la liaison électrique entre les électrodes du résonateur et l'extérieur du boîtier est assurée par deux fils ou deux bandes métalliques qui traversent une partie isolante de l'embase et dont les extrémités internes sont soudées ou collées à l'aide d'une colle conductrice sur des plages de contact du résonateur, de façon que ces fils ou ces bandes servent en même temps de support pour ce résonateur.

Les résonateurs à diapason en quartz ont l'avantage de pouvoir être fabriqués en très grande série et à des prix de revient très bas, par des techniques photolithographiques, ce qui fait qu'ils sont également très souvent utilisés tels quels avec un autre type de boîtiers, en particulier pour des applications non horlogères.

Ces boîtiers d'un autre type dits « boîtiers céramiques », sont des boîtiers relativement plats qui comprennent généralement une partie principale de forme parallélépipédique en matériau céramique, à l'intérieur de laquelle est monté le résonateur, un couvercle rectangulaire avec ou sans rebord, qui peut être en céramique, en verre ou en métal et qui est soudé par l'intermédiaire d'un joint étanche sur la partie principale et un système de connexion qui peut se présenter sous différentes formes pour relier électriquement les électrodes d'excitation du résonateur à l'extérieur du boîtier.

Or, le montage d'un résonateur à diapason dans ce genre de boîtier pose des problèmes.

L'un de ces problèmes est que les caractéristiques dimensionnelles et fonctionnelles des résonateurs sont optimisées pour les monter dans des boîtiers métalliques et pas dans des boîtiers céramiques. Par exemple, le rapport entre leur longueur et leur largeur convient mal pour la fabrication de tels boîtiers, en particulier lorsque ces boîtiers sont de type SMD (sigle de l'appellation anglaise « Surface Mounting Device »), c'est-à-dire prévus pour être montés automatiquement sur des circuits imprimés sans trous.

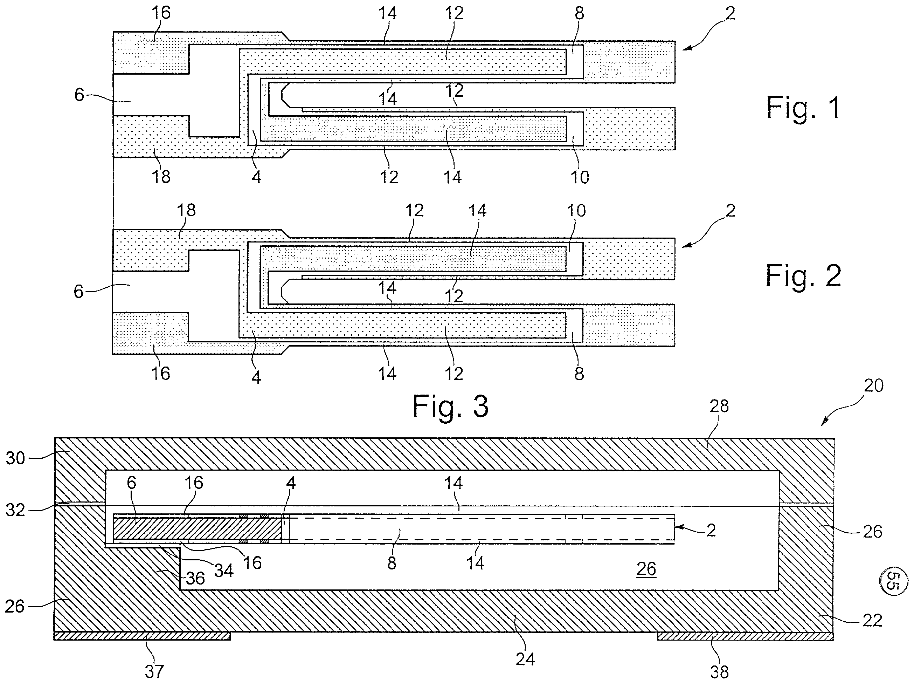

Les figures 1 et 2 sont destinées à mieux faire comprendre d'autres problèmes que pose le montage d'un diapason dans un boîtier céramique.

Ces figures sont des vues en plan de dessus et de dessous d'un résonateur à diapason classique, comme ceux qui sont utilisés actuellement en horlogerie et qui sont conçus pour vibrer en mode de flexion.

Ce résonateur 2 comprend un diapason en quartz 4 dont la base 6 et les branches 8 et 10 portent des métallisations qui forment sur ces branches deux groupes d'électrodes 12 et 14 qui permettent de les soumettre à des champs électriques pour les faire vibrer et sur la base 6 des plages de connexion 16 et 18 reliées respectivement aux groupes d'électrodes 12 et 14.

La figure 3 est une vue en coupe médiane et longitudinale qui montre schématiquement comment le résonateur 2 des figures 1 et 2 est monté généralement dans un boîtier en céramique 20 de type SMD.

Ce boîtier 20 de forme parallélépipédique comprend une partie principale 22 avec un fond 24 et des côtés 26 et un couvercle 28 avec un rebord 30 qui a été soudé sous vide, par chauffage et par pression, en utilisant un joint de soudure 32 par exemple en alliage eutectique d'or et d'étain, après que le résonateur 2 ait été monté dans la partie principale 22.

Ce montage du résonateur 2 se fait en soudant ou en collant avec une colle conductrice les plages de connexion 16 et 18 de la face arrière (voir figure 2) sur des plages conductrices correspondantes 34 prévues sur un échelon 36 du fond 24 situé d'un côté de la partie principale 22 du boîtier, ces plages 34 étant reliées d'une façon non représentée sur le dessin à des plages de contact extérieures 37 et 38 disposées sur la face arrière du fond 24.

Dans ces conditions, une grande partie du résonateur se trouve en porte-à-faux par rapport à l'échelon 36 du fond du boîtier qui le supporte et cet échelon 36 est relativement éloigné du centre de gravité du résonateur.

A cause de cela, le résonateur et sa liaison avec le boîtier ne présentent pas une très bonne résistance aux chocs.

D'autre part, le résonateur risque de basculer vers le fond du boîtier au moment où il est fixé sur l'échelon 36 de ce boîtier.

De plus, comme les coefficients de dilatation thermique de la céramique et du quartz sont assez différents pour créer des tensions mécaniques dans le résonateur qui peuvent non seulement se faire sentir dans les branches du diapason et perturber le fonctionnement du résonateur lorsque la température change mais également dessouder ou décoller plus ou moins les plages de connexion 16 et 18 du résonateur de celles 34 du boîtier et altérer ou même couper la liaison électrique entre les électrodes du résonateur et les plages de contact extérieures 37 et 38 du boîtier.

Pour la même raison, si il y a une amorce de rupture du côté de la base 6 du diapason où se trouvent les plages de connexion 16 et 18 une variation importante de température peut aller jusqu'à la cassure du diapason.

Enfin, lorsque le résonateur est emboîté sous vide, ce vide n'est jamais parfait et le brassage de l'atmosphère par les banches du diapason lorsque le résonateur vibre peut modifier les paramètres de fonctionnement de ce résonateur lorsque ses branches se rapprochent l'une de l'autre, plus que dans le cas d'un boîtier métallique.

Document DE 199 023 39 divulgue un résonateur à diapason double utilisé comme senseur de vitesse angulaire, le résonateur ayant une branche centrale arrangée entre les branches des deux diapasons, la branche centrale incluant des plages de connexion des électrodes des diapasons.

Document JP 54-003487 décrit un boîtier comprenant un résonateur à diapason ayant une branche centrale arrangée entre les branches du diapason.

Document JP 50-85170 divulgue un résonateur à diapason ayant une branche centrale arrangée entre les branches du diapason, la branche centrale incluant les plages de connexion des électrodes du diapason ainsi que le support de contact avec le substrat sur lequel résonateur est monté.

JP 02-268220, GB 1 465 863, GB 1 425 435 et JP 58-150317 divulguent des résonateurs connus dans le domaine de la demande, ainsi que des détails de leur montage sur le support correspondant où dans un boîtier hermétique.

Le but de l'invention est de fournir un résonateur piézoélectrique ainsi qu'un ensemble comprenant ce résonateur enfermé dans un boîtier qui permettent d'apporter des solutions satisfaisantes à ces différents problèmes que posent les résonateurs à diapason classiques.

Pour cela, l'invention propose un résonateur suivant la définition de la revendication 1. Des caractéristiques optionnelles sont définies dans les revendications dépendantes.

D'autres caractéristiques et avantages de l'invention apparaîtront à la lecture de la description qui suit et qui se réfère aux dessins annexés dans lesquels :
- les figures 1 et 2 sont des vues respectivement de dessus et de dessous d'un résonateur à diapason connu dont il a été question précédemment;
- la figure 3 est une vue en coupe médiane et longitudinale dont il a également déjà été question et qui montre comment un résonateur comme celui des figures 1 et 2 est généralement monté dans un boîtier en céramique de type SMD;
- les figures 4 et 5 sont des vues respectivement de dessous et de dessus d'une première forme d'exécution d'un résonateur piézoélectrique selon l'invention;
- la figure 6 est une vue en perspective éclatée et en coupe médiane et longitudinale montrant comment le résonateur des figures 4 et 5 est monté dans un boîtier qui lui est adapté pour former un ensemble résonateur-boîtier conforme à l'invention ;
- la figure 7 est une vue en perspective et en coupe médiane et longitudinale qui montre le résonateur après qu'il ait été monté dans le boîtier ;
- les figures 8 et 9 sont des vues respectivement de dessus et de dessous d'un résonateur piézoélectrique selon un exemple utile pour comprendre l'invention; et
- la figure 10 est une vue analogue à celle de la figure 7 montrant le résonateur des figures 8 et 9 après qu'il ait été monté dans un boîtier adéquat.

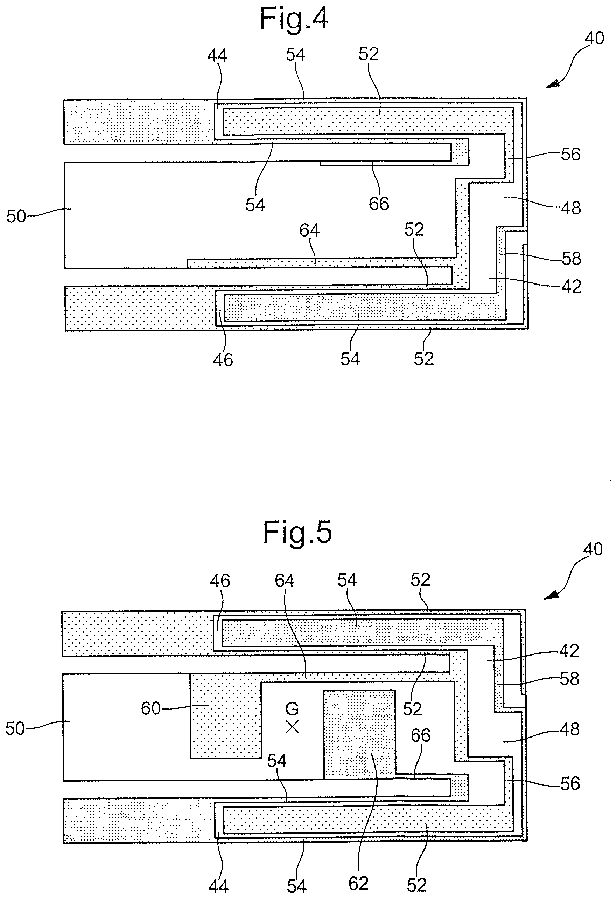

Dans la première forme d'exécution représentée aux figures 4 et 5 le résonateur selon l'invention, désigné par le numéro de référence 40, comprend une partie en forme de diapason 42 avec deux branches 44 et 46 réunies par une base 48 à laquelle est rattachée une branche centrale 50 située entre les branches 44 et 46 et parallèle à celles-ci, le tout étant réalisé en une seule pièce et en quartz.

Telle qu'elle est représentée sur les figures 4 et 5, la branche centrale 50 a une largeur un peu supérieure au double de celle d'une branche 44 ou 46 de la partie 42 en forme de diapason mais cette largeur pourrait être un peu plus grande ou un peu plus faible.

De même, la longueur de la branche centrale 50 n'est pas forcément égale à celle des branches 44 et 46, comme le montrent les figures 4 et 5. Elle pourrait être par exemple plus courte.

Par contre, il est important que d'une part cette branche centrale 50 soit sensiblement à égale distance des branches 44 et 46, cette distance pouvant être égale à celle qui sépare les branches d'un résonateur à diapason classique, comme celui des figures 1 et 2, qui aurait les mêmes dimensions, et que, d'autre part et pour des raisons qui apparaîtront par la suite, cette branche centrale présente une masse beaucoup plus grande que celle des branches 44 et 46 qui doivent vibrer.

Cela dit, comme le montrent les figures 4 et 5, les branches 44 et 46 portent deux groupes d'électrodes 52 et 54 semblables à celles du résonateur des figures 1 et 2 et qui sont reliées entre elles par des pistes conductrices 56, respectivement 58, portées par la base 48 de la partie en forme de diapason 42.

Telles qu'elles sont représentées sur le dessin ces électrodes et ces pistes conductrices sont disposées pour faire vibrer les branches 44 et 46 en mode de flexion mais elles pourraient avoir une autre configuration pour faire vibrer ces branches selon ce même mode ou un autre mode (torsion, cisaillement, etc.).

Pour en revenir à la branche centrale 50, la figure 5 montre qu'elle porte sur sa face arrière deux plages conductrices de connexion 60 et 62 situées de part et d'autre du centre de gravité G du résonateur dans le sens de sa longueur et de préférence à égale distance de celui-ci, ces plages 60 et 62 étant reliées par des pistes conductrices 64 et 66 respectivement aux pistes conductrices 56 et 58 qui relient entre elles les électrodes de chaque groupe 52 et 54.

Si l'on compare le résonateur 40 qui vient d'être décrit au résonateur à diapason 2 des figures 1 et 2 on constate que dans sa direction longitudinale sa base 48 est beaucoup plus étroite que celle 6 du résonateur 2. Ceci est dû au fait que cette base 48 n'a plus à porter des plages de connexion qui servent à la fois à monter le résonateur dans un boîtier et à relier électriquement ses électrodes à l'extérieur de ce boîtier, ce qui, comme on le verra par la suite, est le rôle des plages de connexion 60 et 62.

D'autre part, il est clair qu'à cause de la troisième branche 50 le résonateur 40 est plus large qu'un résonateur à diapason classique dont les branches auraient les mêmes dimensions que celles des branches 44 et 46. Pour des prototypes déjà réalisés par la demanderesse cette augmentation est d'environ 30% mais, pour une raison qui sera indiquée par la suite, le fait qu'un résonateur selon l'invention soit à la fois plus court et plus large qu'un résonateur à diapason classique peur présenter un avantage.

Enfin, il est utile de noter qu'un résonateur comme le résonateur 40 peut être fabriqué en aussi grande série et à un prix pratiquement aussi bas qu'un résonateur à diapason classique et en utilisant les mêmes techniques.

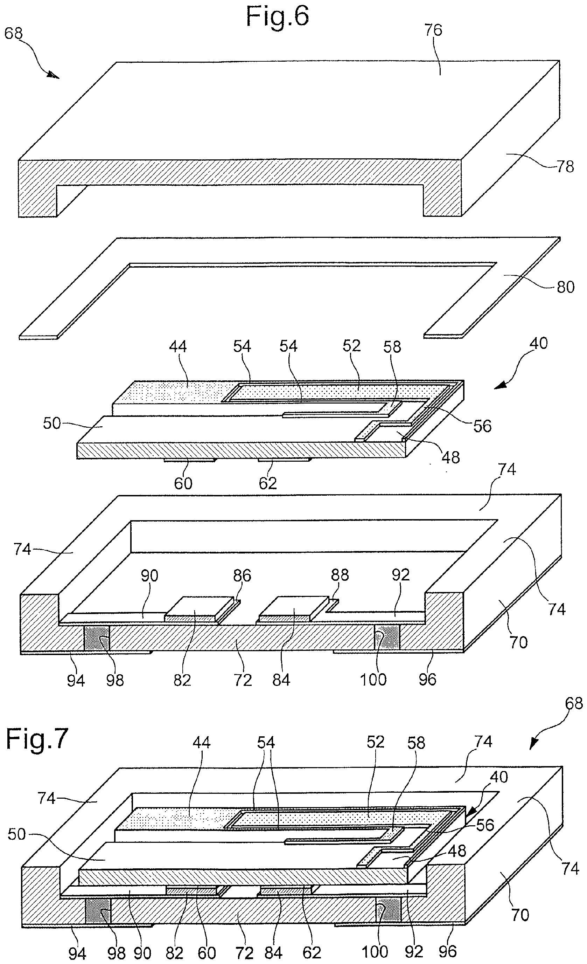

Les figures 6 et 7 montrent comment le résonateur des figures 4 et 5 peut être monté dans un boîtier céramique pour former un ensemble conforme à l'invention.

Comme on peut le voir sur la figure 6, ce boîtier de forme parallélépipédique désigné par le numéro de référence 68, et dont une moitié seulement est représentée comprend une partie principale 70 constituée par un fond plat 72 et quatre côtés 74 et un couvercle 76 avec un rebord 78 par lequel ce couvercle est soudé sous vide, sur les côtés 74 de la partie principale 70, par chauffage et par pression, au moyen d'un cadre de soudure 80, après que le résonateur 40 ait été monté dans la partie principale 70.

Ce montage du résonateur se fait en soudant ou en collant à l'aide d'une colle conductrice ses plages de connexion 60 et 62 sur des plots respectifs 82 et 84, comme le montre la figure 7.

En regardant la figure 7, on voit que ces plots 82 et 84 reposent sur des plages conductrices 86 et 88 situées dans le fond de la partie principale 70 et que ces plages 86 et 88 sont reliées électriquement à des plages de contact extérieures 94 et 96 par des pistes internes 90 et 92 et par de la colle conductrice qui remplit des trous 98 et 100 percés dans le fond 72 du boîtier, au droit des pistes internes 90 et 92.

Tels qu'ils sont représentés sur le dessin, les plots 82 et 84 peuvent être formés en déposant galvaniquement des couches épaisses d'or sur les plages conductrices 86 et 88 mais ils pourraient être réalisés autrement. Par exemple, ces plots pourraient être constitués par des petites pièces en céramique collées sur les plages 86 et 88 et les plages de connexion 60 et 62 du résonateur pourraient alors être collées sur ces pièces en céramique à l'aide d'une colle conductrice qui les entourerait complètement afin d'assurer une liaison électrique entre les plages 60 et 62 et les plages 86 et 88.

Dans tous les cas, le fait de fixer le résonateur au fond du boîtier, dans la zone de son centre de gravité, rend son montage plus facile et minimise le risque qu'il bascule lors de ce montage.

Pour la même raison la résistance aux chocs du résonateur emboîté est beaucoup plus grande.

D'autre part, grâce à la présence des plots 82 et 84 le résonateur n'est plus en contact aussi direct avec le boîtier que le résonateur à diapason des figures 1 à 3. Les contraintes subies par le résonateur à cause de la différence entre les coefficients de dilatation thermique entre le quartz et la céramique qui compose la boîtier sont donc très atténuées et même si ce n'était pas le cas ces contraintes ne s'exerceraient que dans une zone de la troisième branche massive 50 entourant le centre de gravité du résonateur et il n'y aurait pratiquement aucun risque pour que ce résonateur se casse ou tout au moins pour que son fonctionnement soit perturbé par ces contraintes.

De plus, étant donné que la troisième branche du résonateur 40 a une masse plus grande que la base d'un résonateur à diapason classique il y a un meilleur découplage entre le résonateur et le boîtier et par conséquent une amélioration des performances du résonateur emboîté.

A cela il faut ajouter que, toujours grâce à la présence de la troisième branche et lorsque le résonateur vibre en mode de flexion, ses deux autres branches sont moins prés l'une de l'autre que dans le cas d'un résonateur à diapason et se rapprochent plutôt de la troisième branche, ce qui fait que le résonateur est beaucoup moins sensible à la pression de l'air résiduel dans le boîtier.

A noter également que lorsque le résonateur 40 est prévu pour vibrer en mode de flexion, le premier harmonique de sa fréquence de vibration est beaucoup plus atténué que pour un résonateur à diapason, ce qui est un avantage si l'on cherche à ce que le résonateur vibre uniquement à sa fréquence fondamentale.

Enfin, le rapport entre la longueur et la largeur d'un résonateur comme le résonateur 40 n'est pas seulement mieux adapté qu'un résonateur à diapason pour être monté dans un boîtier de type SMD. Ce rapport peut être calculé de façon que, tout en étant aussi performant, le résonateur puisse être monté dans un boîtier non pas de forme rectangulaire mais carrée, pour faciliter la fabrication de ce boîtier, et en donnant aux plots 82, 84 et aux plages 86, 88 une forme adéquate, par exemple celle d'un L, et en les disposant correctement, par exemple de façon que les L forment un carré, sans bien entendu se toucher, il est possible de placer le résonateur dans le boîtier dans quatre positions différentes, pour faciliter également le montage automatisé du résonateur. Une autre solution moins intéressante consisterait à multiplier par deux le nombre de plots et de plages.

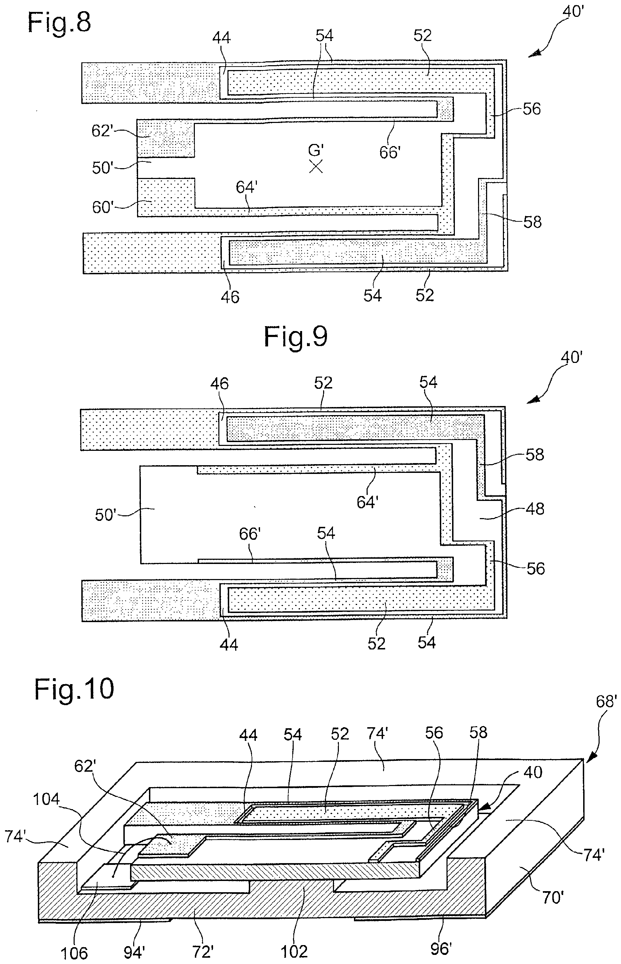

Les figures 8 et 9 représentent vue de dessus et de dessous d'un exemple utile pour comprendre l'invention.

Si l'on compare le résonateur 40' de ces figures 8 et 9 à celui 40 des figures 4 et 5 on constate qu'ils comprennent tous les deux la même partie en forme de diapason et que seule la branche centrale est différente. Il n'est donc pas utile de décrire à nouveau cette partie en forme de diapason dont les divers éléments sont désignés par les mêmes numéros de référence sur les figures 8 et 9 que sur les figures 4 et 5.

Toujours en comparant ces figures, on s'aperçoit qu'il y a en fait trois différences entre la branche centrale 50 du résonateur des figures 4 et 5 et celle 50' du résonateur 40' des figures 8 et 9. Premièrement, elle est un peu courte que les branches 44 et 46 de la partie en forme de diapason. Deuxièmement, elle ne porte plus deux plages de connexion sur sa face arrière mais deux plages de connexion 60' et 62' sur sa face avant, qui sont reliées par des pistes conductrices 64' et 66' à celles 56 et 58 qui connectent entre elles les électrodes 52 et 54 des branches 44 et 46 de la partie 42 en forme de diapason. Et troisièmement, ces plages de connexion 60' et 62' ne sont plus situées de part et d'autre du centre de gravité G' du résonateur mais en bout de la branche centrale 50', du côté de son extrémité libre.

La figure 10 qui correspond à la figure 7 montre comment le résonateur 40' peut être monté dans un boîtier parallélépipédique 68' en céramique pour former un ensemble résonateur-boîtier.

Ce boîtier 68' comprend une partie principale 70' dont une moitié seulement est visible sur la figure et qui est constituée par un fond 72' et quatre côtés 74'.

Pour permettre le montage du résonateur 40' la face interne du fond 72' présente un bossage 102 de forme parallélépipédique dont la dimension dans le sens de la largeur du boîtier est de préférence sensiblement égale ou légèrement inférieure à la largeur de la branche centrale 50' du résonateur et qui est situé de façon que son centre se trouve à peu près à la verticale du centre de gravité G' du résonateur lorsque ce dernier est fixé par exemple par collage sur ce bossage.

A noter que, selon cet exemple, le bossage 102 du fond 72' pourrait être remplacé par une pièce en céramique ou en un autre matériau isolant fixée par exemple par collage au fond du boîtier. Cet autre matériau pourrait même être avantageusement choisi pour présenter un coefficient de dilatation thermique compris entre ceux de la céramique du boîtier et du quartz du résonateur afin de diminuer les contraintes subies par la branche centrale 50' de ce résonateur dues à des différences de température.

A noter également que le bossage 102 ne sert plus qu'à supporter le résonateur et ne joue plus de rôle dans la liaison électrique entre ce résonateur et des plages de contact 94' et 96' extérieures du boîtier.

Ce rôle de liaison électrique est assuré par des fils conducteurs 104 dont un seul est visible sur la figure 10 et dont une extrémité est fixée par soudage ou collage à l'aide d'une colle conductrice sur les plages de connexion 60' et 62' du résonateur (voir figure 8) et dont l'autre extrémité est fixée de la même façon sur des plages conductrices 106 situées dans le fond du boîtier, selon la technique bien connue du « wire bonding ».

La plage conductrice 106 qui est la seule visible sur la figure 10 peut être reliée électriquement directement à la plage extérieure 94' par une colle conductrice remplissant un trou traversant percé dans le fond 72 du boîtier qui n'apparaît pas sur la figure 10. L'autre plage conductrice 106 qui n'est pas non plus visible sur la figure 10 peut être connectée à la plage extérieure 96' de la même façon mais par l'intermédiaire d'une piste conductrice portée par le fond du boîtier.

Pour éviter de réduire la masse de la troisième branche 50' du résonateur et de rapprocher le centre de gravité G' de ce dernier de sa base 48 il serait possible que cette troisième branche ait la même longueur que les branches 44 et 46 de la partie en forme de diapason 42 mais à cause de la façon dont les plages de connexion 60' et 62' du résonateur sont reliées aux plages 106 du boîtier cela pourrait obliger à augmenter la longueur de ce boîtier, ce qui ne serait pas souhaitable. Par ailleurs, pour mieux découpler mécaniquement la partie en forme de diapason du résonateur de sa branche centrale cette dernière pourrait présenter des encoches pour réduire sa largeur à l'endroit de son rattachement à la partie principale.

D'autre part, même si il n'est pas conçu spécialement pour être inclus dans un boîtier carré, le résonateur selon l'invention pourrait très bien être monté sur plus de deux plots, par exemple trois, afin de lui assurer une meilleure assise.

De plus, les pistes conductrices internes du boîtier pourraient être reliées aux plages de contact extérieures autrement que par des trous percés dans le fond de ce boîtier et remplis de colle conductrice.

Enfin, bien que le résonateur selon l'invention ait été plus spécialement conçu pour être placé dans des boîtiers en céramique, il pourrait également être inclus dans des boîtiers hybrides comprenant une partie principale en céramique et un couvercle en verre ou en métal ou dans des boîtiers totalement en verre ou en métal, comme cela a déjà été proposé pour des résonateurs à diapason classiques et en adaptant bien évidemment ces boîtiers au résonateur selon l'invention.

## Revendications

1. Ensemble comprenant un résonateur piézoélectrique (40 ;40') et un boîtier hermétique (68) de forme parallélépipédique, comportant une partie principale (70) avec un fond (72) et des côtés (74), dans laquelle est monté ledit résonateur et un couvercle (76) fixé sur cette partie principale, ledit résonateur comprenant une partie en forme de diapason (42) avec deux branches parallèles (44 ;46), reliées entre elles par une base (48) et portant des électrodes (52,54) pour les faire vibrer, ces électrodes étant reliées à deux plages de connexion (60,62 ;60',62') prévues pour être reliées électriquement à l'extérieur dudit boîtier, le résonateur comprennant également une branche centrale (50 ;50') rattachée à ladite base (48) et située entre les deux branches parallèles (44,46) de la partie en forme de diapason (42), sensiblement à égale distance de celles-ci, lesdites deux plages de connexion (60, 62, 60', 62') étant portées par cette branche centrale (50, 50'), **caractérisé par le fait que** la branche centrale du résonateur a une masse supérieure à celle des deux branches parallèles de la partie en forme de diapason, et **par le fait que** le boîtier comprend au moins deux supports (82,84) solidaires de deux plages conductrices (86,88) situées dans le fond (72) du boîtier, ladite branche centrale étant fixée à l'endroit de ses deux plages de connexion (60,62 ;60',62') sur les deux supports (82,84), de façon que lesdites deux plages de connexion soient reliées électriquement aux deux plages conductrices (86,88), les deux plages conductrices étant elles-mêmes reliées électriquement à l'extérieur du boîtier.

2. Ensemble selon la revendication 1, **caractérisé par le fait que** ladite partie en forme de diapason (42) et ladite branche centrale (50 ;50') du résonateur (40 ;40') sont constituées par une seule pièce en quartz.

3. Ensemble selon la revendication 1, **caractérisé par le fait que** ladite branche centrale (50 ;50') du résonateur (40,40') a une largeur supérieure ou égale au double de la largeur des deux branches parallèles (44,46) de la partie en forme de diapason (42).

4. Ensemble selon la revendication 1, **caractérisé par le fait que** ladite branche centrale (50) du résonateur (40) a une longueur sensiblement égale à celle des deux branches parallèles (44,46) de la partie en forme de diapason (42).

5. Ensemble selon la revendication 1, **caractérisé par le fait que** ladite branche centrale (50') du résonateur (40') a une longueur inférieure à celle des deux branches parallèles (44,46) de la partie en forme de diapason (42).

6. Ensemble selon la revendication 1, **caractérisé par le fait que** ladite branche centrale (50) du résonateur (40) porte sur sa face arrière orientée vers le fond (72) du boîtier (68) lesdites deux plages de connexion (62,64) situées de part et d'autre du centre de gravité G du résonateur (40), dans la direction longitudinale de ce résonateur.

7. Ensemble selon la revendication 6, **caractérisé par le fait que** lesdites deux plages de connexion (62,64) du résonateur (40) sont situées sensiblement à égale distance dudit centre de gravité G .

8. Ensemble selon la revendication 1, **caractérisé par le fait que** ladite branche centrale (50') du résonateur (40') porte sur l'une de ses faces desdites deux plages de connexion (60',62') situées en bout de cette branche, du côté de son extrémité libre.

9. Ensemble selon la revendication 1, **caractérisé par le fait que** lesdits deux supports (82 ;84) sont des plots formés par des couches épaisses d'un métal déposées sur lesdites plages conductrices (86,88).

10. Ensemble selon la revendication 1, **caractérisé par le fait que** lesdits deux supports (82 ;84) sont des plots (82,84) constitués par des pièces en matériau électriquement isolant fixées sur lesdites plages conductrices (86,88) et sur lesquelles sont fixées par une colle conductrice lesdites deux plages de connexion (62,64) du résonateur (40 ;40'), de façon que cette colle entoure lesdites pièces pour relier électriquement lesdites deux plages de connexion auxdites plages conductrices.

11. Ensemble selon la revendication 1, **caractérisé par le fait que** la partie principale (70) et le couvercle (76) du boîtier (68 ;68') sont en céramique.

12. Ensemble selon la revendication 11, **caractérisé par le fait que** lesdites plages conductrices (82,84) sont reliées électriquement à des plages de contact extérieures (94,96) portées par ledit fond (72) de la partie principale (70) du boîtier par des pistes conductrices internes (90,92) et de la colle conductrice remplissant des trous (98,100) percés dans ledit fond (72).

13. Ensemble selon la revendication 1, **caractérisé par le fait que** le résonateur (40 ;40') est conçu pour vibrer en mode flexion.

## Patentansprüche

1. Anordnung, umfassend einen piezoelektrischen Resonator (40; 40') und ein parallelepipedförmiges, hermetisches Gehäuse (68), das einen Hauptteil (70) mit einem Boden (72) und Seiten (74), in dem der Resonator montiert ist, und eine an diesem Hauptteil befestigte Abdeckung (76) umfasst, wobei der Resonator einen Teil in Form einer Stimmgabel (42) mit zwei parallelen Zinken (44; 46) aufweist, die durch eine Basis (48) miteinander verbunden sind und Elektroden (52, 54) tragen, um sie in Schwingung zu versetzen, wobei diese Elektroden mit zwei Anschlussbereichen (60, 62; 60', 62') verbunden sind, vorgesehen zur elektrischen Verbindung mit dem Äußeren des Gehäuses, wobei der Resonator ferner eine mittlere Zinke (50; 50') aufweist, die an die Basis (48) angefügt ist und zwischen den beiden parallelen Zinken (44, 46) des Teils in Form einer Stimmgabel (42) im Wesentlichen im gleichen Abstand von diesen angeordnet ist, wobei die beiden Verbindungsbereiche (60, 62, 60', 62') von dieser mittleren Zinke (50, 50') getragen werden,
**dadurch gekennzeichnet, dass** die mittlere Zinke des Resonators eine Masse größer als jene der beiden parallelen Zinken des Teils in Form einer Stimmgabel besitzt, und dass das Gehäuse mindestens zwei Auflager (82, 84) aufweist, die mit zwei im Boden (72) des Gehäuses angeordneten leitenden Bereichen (86, 88) fest verbunden sind, wobei die mittlere Zinke am Ort ihrer beiden Verbindungsbereiche (60, 62; 60', 62') auf den beiden Auflagern (82, 84) so befestigt ist, dass die beiden Verbindungsbereiche mit den beiden leitenden Bereichen (86, 88) elektrisch verbunden sind, wobei die beiden leitenden Bereiche ihrerseits mit der äußeren Umgebung des Gehäuses elektrisch verbunden sind.

2. Anordnung nach Anspruch 1, **dadurch gekennzeichnet, dass** der Teil in Form einer Stimmgabel (42) und der mittlere Zinken (50; 50') des Resonators (40; 40') aus einem einzigen Quarzstück gebildet sind.

3. Anordnung nach Anspruch 1, **dadurch gekennzeichnet, dass** die mittlere Zinke (50; 50') des Resonators (40, 40') eine Breite größer oder gleich der doppelten Breite der beiden parallelen Zinken (44, 46) des Teils in Form einer Stimmgabel (42) besitzt.

4. Anordnung nach Anspruch 1, **dadurch gekennzeichnet, dass** die mittlere Zinke (50) des Resonators (40) eine Länge im Wesentlichen gleich jener der beiden parallelen Zinken (44, 46) des Teils in Form einer Stimmgabel (42) besitzt.

5. Anordnung nach Anspruch 1, **dadurch gekennzeichnet, dass** die mittlere Zinke (50') des Resonators (40') eine Länge kleiner als jene der beiden parallelen Zinken (44, 46) des Teils in Form einer Stimmgabel (42) besitzt.

6. Anordnung nach Anspruch 1, **dadurch gekennzeichnet, dass** die mittlere Zinke (50) des Resonators (40) auf ihrer hinteren, zum Boden (72) des Gehäuses (68) gerichteten Fläche die beiden Verbindungsbereiche (62, 64) trägt, die in Längsrichtung dieses Resonators beiderseits des Schwerpunkts G des Resonators (40) angeordnet sind.

7. Anordnung nach Anspruch 6, **dadurch gekennzeichnet, dass** die beiden Verbindungsbereiche (62, 64) des Resonators (40) im Wesentlichen im gleichen Abstand vom Schwerpunkt G angeordnet sind.

8. Anordnung nach Anspruch 1, **dadurch gekennzeichnet, dass** die mittlere Zinke (50') des Resonators (40') auf einer ihrer Flächen die beiden Verbindungsbereiche (60', 62') trägt, die am Ende dieser Zinke auf der Seite ihres freien Endes angeordnet sind.

9. Anordnung nach Anspruch 1, **dadurch gekennzeichnet, dass** die beiden Auflager (82; 84) Kontakte sind, die aus dicken Schichten eines Metalls bestehen, das auf den leitenden Bereichen (86, 88) abgeschieden ist.

10. Anordnung nach Anspruch 1, **dadurch gekennzeichnet, dass** die beiden Auflager (82; 84) Kontakte (82, 84) sind, gebildet durch Teile aus elektrisch isolierenden Material, die auf den leitenden Bereichen (86, 88) befestigt sind und auf denen mittels eines leitenden Klebstoffs die beiden Verbindungsbereiche (62, 64) des Resonators (40; 40') befestigt sind, derart, dass dieser Klebstoff die Teile zum elektrischen Verbinden der beiden Verbindungsbereiche mit den leitenden Bereichen umgibt.

11. Anordnung nach Anspruch 1, **dadurch gekennzeichnet, dass** der Hauptteil (70) und die Abdeckung (76) des Gehäuses (68; 68') aus Keramik hergestellt sind.

12. Anordnung nach Anspruch 11, **dadurch gekennzeichnet, dass** die leitenden Bereiche (82, 84) elektrisch verbunden sind mit äußeren Kontaktbereichen (94, 96), die vom Boden (72) des Hauptteils (70) des Gehäuses getragen werden, durch innere Leiterbahnen (90, 92) und den leitenden Klebstoff, der die in dem Boden (72) ausgesparten Löcher (98, 100) füllt.

13. Anordnung nach Anspruch 1, **dadurch gekennzeichnet, dass** der Resonator (40; 40') dafür ausgelegt ist, im Biegemodus zu schwingen.

## Claims

1. Assembly comprising a piezoelectric resonator (40; 40') and a hermetic case (68) of parallelepipedic shape, including a main part (70) with a bottom (72) and sides (74), wherein said resonator is mounted and a cover (76) fixed to this main part, said resonator including a tuning fork shaped part (42) with two parallel arms (44; 46) connected to each other by a base (48) and carrying electrodes (52, 54) to make them vibrate, these electrodes being connected to two connection pads (60, 62; 60', 62') envisaged to be electrically connected to the exterior of said case, the resonator also comprising a central arm (50; 50') attached to said base (48) and located between two parallel arms (44, 46) of the tuning fork shaped part (42), substantially equidistant from the latter, said two connection pads (60, 62, 60', 62') being carried by this central arm (50, 50'), **characterised in that** the central arm has a greater mass than that of the two parallel arms of the tuning fork shaped part, and **in that** the case includes at least two supports (82, 84) secured to two conductive pads (86, 88) located in the bottom (72) of the case, said central arm being fixed at the location of the two connection pads (60, 62, 60', 62') thereof on the two supports (82, 84), such that said two connection pads are electrically connected to the two conductive pads (86, 88), the two conductive pads being themselves electrically connected to the exterior of the case.

2. Assembly according to claim 1, **characterised in that** said tuning fork shaped part (42) and said central arm (50; 50') of the resonator (40; 40') are formed by a single piece made of quartz.

3. Assembly according to claim 1, **characterised in that** the width of said central arm (50; 50') of the resonator (40, 40') is greater than or equal to twice the width of the two parallel arms (44, 46) of the tuning fork shaped part (42).

4. Assembly according to claim 1, **characterised in that** the length of said central arm (50) of the resonator (40) is substantially equal to that of the two parallel arms (44, 46) of the tuning fork shaped part (42).

5. Assembly according to claim 1, **characterised in that** the length of said central arm (50') of the resonator (40') is less than that of the two parallel arms (44, 46) of the tuning fork shaped part (42).

6. Assembly according to claim 1, **characterised in that** said central arm (50) of the resonator (40) carries on its back face oriented towards the bottom (72) of the case (68) said two connection pads (62, 64) located on either side of the centre of gravity G of the resonator (40), in the longitudinal direction of this resonator.

7. Assembly according to claim 6, **characterised in that** said two connection pads (62, 64) of the resonator (40) are located substantially equidistant from said centre of gravity G.

8. Assembly according to claim 1, **characterised in that** said central arm (50') of the resonator (40') carries on one of its faces said two connection pads (60', 62') located at the end of said arm, on the side of its free end.

9. Assembly according to claim 1, **characterised in that** said supports (82; 84) are studs formed by thick metal layers deposited on said conductive pads (86, 88).

10. Assembly according to claim 1, **characterised in that** said supports (82; 84) are studs (82, 84) consisting of parts made of electrically insulating material fixed on said conductive pads (86, 88) and whereon said two connection pads (62, 64) of the resonator (40; 40') are fixed by a conductive adhesive, such that this adhesive surrounds said parts to electrically connect said two connection pads to said conductive pads.

11. Assembly according to claim 1, **characterised in that** the main part (70) and the cover (76) of the case (68; 68') are made of ceramic material.

12. Assembly according to claim 11, **characterised in that** said conductive pads (82, 84) are electrically connected to external contact pads (94, 96) carried by said bottom (72) of the main part (70) of the case by inner conductive paths (90, 92) and conductive adhesive filling holes (98, 100) pierced in said bottom (72).

13. Assembly according to claim 1, **characterised in that** the resonator (40; 40') is designed to vibrate in flexure mode.
